Europäisches Patentamt

European Patent Office

Office européen des brevets

(19)

(11) Numéro de publication : **0 523 221 B1**

(12) **FASCICULE DE BREVET EUROPEEN**

(45) Date de publication du fascicule du brevet :
27.12.95 Bulletin 95/52

(51) Int. Cl.⁶ : **G01R 29/08**

(21) Numéro de dépôt : **92905358.5**

(22) Date de dépôt : **29.01.92**

(86) Numéro de dépôt international :
**PCT/FR92/00080**

(87) Numéro de publication internationale :
**WO 92/14164 20.08.92 Gazette 92/22**

(54) **MESURE DE LA TEMPERATURE D'UN MATERIAU, UTILISANT LE RAYONNEMENT MICRO-ONDE**

(30) Priorité : **01.02.91 FR 9101344**

(43) Date de publication de la demande :
**20.01.93 Bulletin 93/03**

(45) Mention de la délivrance du brevet :
**27.12.95 Bulletin 95/52**

(84) Etats contractants désignés :
**AT BE CH DE DK ES GB GR IT LI LU MC NL SE**

(56) Documents cités :
**EP-A- 0 159 279**
**EP-A- 0 294 854**
**FR-A- 2 650 390**
**L'onde Electrique, vol. 69, no. 5, septembre/octobre 1989, (Paris, FR), D. VANLOOT et al.: "Nouveau dispositif électronique de traitement du signal basse
fréquence dans les radiomètres à usages médicaux", pages 60-65, voir pages 60-**

(56) Documents cités :
**Conference Proceedings, 19th European Microwave Conference, Londres, 4-7 septembre 1989, Microwave Exhibitions and Publishers Ltd, I.M. ANGELOV et al.: "Radiometer for microwave thermography", pages 924-929
IEEE Transactions on Microwave Theory and Techniques, vol. 36, no. 1, janvier 1988, (New York, NY, US), Y. KATO et al.: "A method for evaluating the noise temperatures of microwave thermal noise sources by introducing and auxiliary transmission line", pages 145-147, voir pages 145-146**

(73) Titulaire : **CENTRE NATIONAL DE LA RECHERCHE SCIENTIFIQUE**
**15, quai Anatole France**
**F-75007 Paris (FR)**

(72) Inventeur : **VAN DE VELDE, Jean-Claude**
**Résidence Europe C7-233,**
**Avenue Schumann**
**F-59370 Mons-en-Baroeul (FR)**
Inventeur : **CONSTANT, Eugène**
**39, avenue du Vieux-Château**
**F-59650 Villeneuve-d'Ascq (FR)**

(74) Mandataire : **Duthoit, Michel Georges André**
**c/o Cabinet Innovations & Prestations**
**23-25 rue Nicolas Leblanc**
**B.P. No. 1069**
**F-59011 Lille Cédex 1 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne la détermination de la température d'un matériau ou d'un objet quelconque ainsi que de son coefficient de réflexion hyperfréquence.

Pour déterminer la température d'un objet, il est connu d'utiliser des procédés de mesure par lesquels on capte les signaux de bruits thermiques émis par cet objet dans le domaine des hyperfréquences, et on établit une correspondance entre la puissance des signaux captés et la température de l'objet.

A ce sujet, le terme "objet" doit être pris dans un sens très large car il peut désigner tout aussi bien un objet matériel mais également un matériau voire même des tissus vivants. En effet, tout corps absorbant émet des signaux de bruits thermiques en rapport direct avec sa température. Ces signaux de bruits thermiques sont émis dans un domaine de fréquence très large.

Pour effectuer la mesure de température, on connaît également d'autres procédés utilisant les signaux émis dans le domaine des infrarouges. Cependant, l'inconvénient réside dans le fait que les signaux captés sont émis principalement par la surface du corps à mesurer et on ne peut alors mesurer que la température de surface.

Un autre mode de mesure de température connu réside dans l'utilisation d'un thermo-couple introduit nécessairement à l'intérieur du corps dont on souhaite mesurer la température. Cependant, dans de très nombreux cas, la pénétration du thermo-couple dans le corps constitue un inconvénient majeur.

Pour éviter ces inconvénients, on préfère prendre en compte les signaux de bruits thermiques émis dans le domaine des hyperfréquences, c'est-à-dire des fréquences variant approximativement entre 0,5 et 20 GHz.

A cet égard, on connaît des dispositifs de radiométrie micro-onde dans lesquels on capte le rayonnement micro-onde émis par l'intermédiaire d'une antenne et on dirige les signaux reçus vers des moyens de traitement des signaux qui permettent de déterminer la température de l'objet considéré.

Cependant, un des principaux problèmes rencontrés en radiométrie hyperfréquence réside dans l'adaptation de l'antenne en présence du matériau dont on veut connaître la température. En effet, l'antenne utilisée présente un coefficient de réflexion $R_o$ et de ce fait l'antenne n'est jamais parfaitement adaptée compte tenu du fait que les objets à mesurer sont généralement de configuration, de taille et de propriété différentes.

Dans ces conditions, l'erreur commise dans la mesure de la température de l'objet, résultant du fait que le coefficient $|R_o|^2$ de l'antenne est différent de zéro, entraîne deux constatations à savoir : d'une part, l'émissivité de l'objet = $1 - |R_o|^2$ est différente de l'unité, et d'autre part, compte tenu du coefficient de réflexion de l'antenne, une partie du bruit émis à l'entrée des moyens de traitement des signaux se trouve réfléchie par l'antenne, puis amplifiée par les dits moyens et contribue de ce fait indûment au signal mesuré à la sortie des dits moyens.

Pour pallier ces différents inconvénients, différents procédés ont été imaginés pour permettre de mesurer la température intérieure d'un corps sans pour autant nécessiter l'introduction dans ce corps de moyens pour capter cette température.

En effet, on connaît du document FR-A-2.497.947 un procédé et un dispositif de thermographie en micro-onde basé sur le principe du radiomètre de Dicke utilisant une antenne, un circulateur, une source auxiliaire de bruit de caractéristiques connues, un amplificateur-récepteur et un détecteur. En outre, selon ce document, l'emploi du circulateur est associé à un commutateur hyperfréquence à deux voies reliant cycliquement la ligne de mesure à l'antenne ou mettant la ligne de mesure en court-circuit.

Ainsi, cet ensemble circulateur-commutateur permet d'une part d'absorber le signal émis à l'entrée de l'amplificateur, et d'autre part de présenter à l'antenne une charge de température sensiblement égale à celle du matériau à mesurer. Dans ces conditions, lorsque le coefficient $|R_o|^2$ est différent de zéro, la diminution de bruit émis par le matériau à mesurer est compensée par le bruit émis par la dite charge et réfléchi par l'antenne.

Toutefois, le procédé et le dispositif FR-A-2.497.947 obligent l'emploi d'un circulateur, ce qui peut être préjudiciable dans certains cas. En effet, le circulateur est généralement constitué par un élément à ferrite déterminé en fonction du domaine de fréquences et dont la taille et le prix sont intangibles. Ceci se répercute donc naturellement sur le coût du dispositif et sur sa dimension, interdisant toute possibilité d'intégration monolithique du dispositif.

Cela étant, on connaît du document FR-A-2.561.769 un procédé de contrôle d'adaptation d'impédance dans les chaînes de réception faible bruit et un thermomètre micro-onde miniature de mise en oeuvre de ce procédé.

Un tel dispositif comporte une antenne, une source de bruit étalon ajustable en température et en impédance, des moyens de commutation assujettis à l'antenne et à la source de bruit étalon, un amplificateur disposé en aval du commutateur, délivrant un signal d'amplitude correspondant à la différence de niveau entre les signaux issus de l'antenne et de la source de bruit étalon, une impédance additionnelle contrôlée pour être placée périodiquement sur l'entrée de l'amplificateur, et des moyens pour analyser l'écart des impédances présentées par l'antenne et la source de bruit étalon, et pour ajuster, en adaptant leur impédance, soit l'antenne, soit la source de bruit, pour égaliser les influences exercées par l'impédance additionnelle sur l'antenne et sur la source de bruit, et par voie de conséquence pour égaliser les impédances présentées par l'antenne et la source de bruit étalon.

Ainsi, le procédé FR-2.561.769 consiste à essayer d'utiliser une source de bruit de référence, dont le coefficient de réflexion réglable électroniquement est rendu égal en module à celui de l'antenne placée en présence de l'objet à mesurer. A cet effet, le bruit émis par l'entrée de l'amplificateur, peut être utilisé pour vérifier l'égalité des deux coefficients de réflexion, et l'on utilise dans ce but une impédance additionnelle variable dont la valeur peut être commandée électroniquement, et qui est placée à l'entrée de l'amplificateur.

Une telle technique permet de s'affranchir du circulateur, mais, malheureusement, ne peut être utilisée que lorsque la charge présentée par l'antenne est résistive et si la longueur de ligne placée entre l'antenne et l'amplificateur est négligeable.

Aux inconvénients des dispositifs connus s'ajoutent d'autres limitations auxquelles il n'est pas possible de répondre. En particulier, lorsqu'on utilise un circulateur, la taille de la ferrite mise en oeuvre est d'autant plus grande que l'on travaille à fréquence faible.Par exemple, à 1 GHz, la taille devient vite prohibitive. En outre, lorsque l'on travaille pour déterminer la température avec une méthode de zéro, généralement on cherche à rendre nul un facteur constitué par la différence entre la température de la source auxiliaire de référence et la température du corps à mesurer. Aussi, il devient délicat de mesurer la température d'un corps de température inférieure à 273°K (°C), ce qui est préjudiciable dans certains cas.

En outre, dans une chaîne de mesure, la suppression de l'élément circulateur n'est pas sans poser de problèmes. En effet, pour un amplificateur de gain g donné, ce dernier présente inévitablement un bruit d'entrée $T_e$ ainsi qu'un bruit de l'amplificateur $T_a$, caractérisant son facteur de bruit. Aussi, dans les circuits à amplification directe, il y a lieu de tenir compte de l'influence d'une éventuelle corrélation entre le bruit d'entrée $T_e$ et le bruit de sortie de l'amplificateur $T_a$ lorsque la charge à l'entrée du circuit n'est pas adaptée.

Les erreurs de mesure dues à la désadaptation dépendent du coefficient de réflexion $R_o$ et des dits bruits $T_e$ et $T_a$.

Pour pallier le phénomène de corrélation, il est connu d'utiliser en parallèle sur la ligne d'entrée de l'amplificateur, des décaleurs de phases apériodiques (phase-shifters) qui permettent d'introduire aléatoirement des phases $-\pi/2$, $+\pi/2$ par exemple dont le but est d'interdire toute possibilité de construction cohérente des bruits et donc d'annuler toute corrélation entre $T_e$ et $T_a$.

Toutefois, de tels décaleurs de phases réduisent l'amplitude des signaux de bruits captés et présentent d'autre part des dimensions importantes qui condamnent toute possibilité d'intégration monolithique du radiomètre.

Le but de la présente invention est de proposer un procédé et un dispositif de mesure de la température d'un matériau ou d'un objet quelconque utilisant le rayonnement micro-onde qui permettent de pallier les inconvénients précités et qui permettent de s'affranchir de l'utilisation d'un circulateur tout en autorisant une mesure précise de la température.

Un des buts de la présente invention est de proposer un procédé et un dispositif de mesure de signaux radiométriques qui puissent par voie de conséquence être réalisés selon des techniques d'intégration monolithique et par suite miniaturisable et de faible coût.

Un autre but de la présente invention est de proposer un procédé de mesure de signaux radiométriques qui puisse être utilisé lorsque l'antenne n'est pas particulièrement adaptée à l'objet à mesurer, ou si la longueur de ligne placée entre l'antenne et l'amplificateur n'est pas négligeable.

Un autre but de la présente invention est de proposer un procédé et un dispositif de mesure de signaux radiométriques qui permettent de s'affranchir de l'influence d'une éventuelle corrélation entre le bruit d'entrée et le bruit de sortie de l'amplificateur lorsque la charge à l'entrée n'est pas adaptée.

Un autre but de la présente invention est de proposer un procédé de mesure de signaux radiométriques qui n'utilise pas le principe du radiomètre de Dicke tout en donnant un résultat équivalent voire supérieur.

En effet, un autre but de la présente invention concerne l'application du procédé de mesure de signaux radiométriques à la détermination du coefficient de réflexion hyperfréquence d'un matériau ou d'un objet quelconque.

D'autres buts et avantages de la présente invention apparaîtront au cours de la description qui va suivre qui n'est cependant donnée qu'à titre indicatif et qui n'a pas pour but de la limiter.

Selon l'invention, le procédé de mesure de la température $T_x$ d'un matériau ou d'un objet quelconque, utilisant le rayonnement micro-onde, par lequel on capte le rayonnement micro-onde émis par l'intermédiaire d'une antenne, présentant un coefficient de réflexion $R_{ox}$, et on dirige les signaux reçus vers des moyens de traitement des signaux, est caractérisé par le fait que l'on intercale, entre l'antenne et les dits moyens, une ligne d'impédance donnée, fonction de l'impédance d'entrée des dits moyens, de longueur L très grande devant la longueur d'onde des signaux telle que le facteur de corrélation des dits moyens soit négligeable.

En outre, selon le procédé de mesure de l'invention, on dirige les signaux reçus par l'antenne, via la dite longueur L de ligne, vers l'entrée des dits moyens de traitement, de gain en puissance $\gamma g$ , de température de bruits d'entrée $T_e$ et de bruits de sortie $T_a$ tels que l'on recueille en sortie des dits moyens de traitement une tension de sortie

$$V_s = g\gamma [T_x(1 - |R_{o\,x}|^2) + T_e |R_{o\,x}|^2 + T_a]$$

puis on calcule périodiquement tous les paramètres en modifiant cycliquement la structure des dits moyens.

A cet égard, pour mettre en oeuvre le procédé de l'invention, le dispositif de mesure présente une ligne intercalaire de longeur L, d'impédance donnée fonction de l'impédance d'entrée des moyens de traitement des signaux, placés entre ces derniers et l'antenne, la dite longueur L étant très grande devant la longueur d'onde des signaux traités.

En outre, les dits moyens de traitement sont constitués d'un récepteur hyperfréquence à amplification directe, suivi d'un détecteur quadratique, et précédé d'un commutateur multi-voies hyperfréquence, apte à modifier la structure des dits moyens cycliquement.

La présente invention sera mieux comprise à la lecture de la description suivante qui n'est cependant donnée qu'à titre indicatif et qui n'a pas pour but de la limiter, accompagnée des dessins qui en font partie intégrante parmi lesquels :

- la figure 1 représente le schéma de fonctionnement du dispositif de mesure de température et/ou de détermination du coefficient de réflexion hyperfréquence d'un matériau ou d'un objet quelconque,
- la figure 2 montre graphiquement l'importance de l'expression du facteur de corrélation, pour une bande passante déterminée d'un ampli, en fonction de la longueur de la ligne L entre l'antenne et l'entrée de l'ampli,
- la figure 3 représente schématiquement la réalisation structurelle d'un commutateur deux voies,
- la figure 4 représente un premier mode de réalisation d'une source de bruit haute impédance introduite dans les dits moyens de la présente invention,
- la figure 5 représente un autre mode de réalisation d'une source de bruit haute impédance introduite dans les dits moyens de la présente invention,
- la figure 6 représente schématiquement un mode de réalisation d'un circuit de mesure de température d'une charge de référence,
- la figure 7 représente schématiquement un autre mode de réalisation d'un circuit de mesure de température d'une charge de référence.

L'invention vise un procédé et un dispositif de mesure de la température d'un matériau ou d'un objet quelconque, utilisant le rayonnement micro-onde, ainsi qu'une application du procédé de mesure pour la détermination du coefficient de réflexion hyperfréquence d'un matériau ou d'un objet quelconque.

Comme nous l'avons signalé précédemment, il faut prendre le terme "objet" ou "matériau" au sens large, désignant la matière d'un corps à mesurer, ce corps pouvant être notamment des objets matériels, des substances ou des tissus vivants.

Par ailleurs, il est également à rappeler que tout matériau porté à une température $T_x$ émet un rayonnement électromagnétique dont la puissance dans le domaine des micro-ondes est proportionnelle à la température et à la bande passante du dispositif de mesure. En particulier, la puissance recueillie par une antenne est donnée par la relation :

$$P = k\,T_x\,\Delta f\,(1 - |R_{o\,x}|^2)$$

dans laquelle k est la constante de Boltzman $(1,38.10^{-23})$, $T_x$ la température du matériau à mesurer, $\Delta f$ la bande passante et $|R_{o\,x}|^2$ le coefficient de réflexion de l'antenne.

Lorsqu'on réalise un radiomètre amplification directe, c'est-à-dire lorsque l'on connecte directement à l'entrée d'un amplificateur-récepteur A une antenne, et à sa sortie un détecteur quadratique D, sans intercaler dans la chaîne de circulateur, la tension $V_s$ en sortie du détecteur est donnée par la relation suivante :

$$V_s = g\gamma [T_x(1 - |R_{o\,x}|^2) + T_e |R_{o\,x}|^2 + T_a]$$

dans laquelle g correspond au gain de l'amplificateur, $\gamma$ correspond au gain de conversion du détecteur, $T_e$ correspond au bruit d'entrée de l'amplificateur et $T_a$ correspond au bruit de l'amplificateur, caractérisant son facteur de bruit.

Cependant, cette relation $V_s$ doit être corrigée de l'erreur de mesure radiométrique causée par une éventuelle corrélation entre le bruit d'entrée $T_e$ et le bruit de sortie $T_a$ de l'amplificateur lorsque la charge à l'entrée du radiomètre n'est pas adaptée.

Le bruit $T_e$ est lié à la température physique de l'ampli et le bruit $T_a$ est lié à l'image de la dégradation qu'apporte l'ampli au bruit d'entrée. On dit qu'il y a corrélation entre $T_e$ et $T_a$.

Ainsi, lorsque l'on ne recourt pas au circulateur, la contribution élémentaire, à une fréquence f, du bruit de corrélation induit par l'amplificateur, est donnée par la relation suivante :

$$d\,S_{cor} = k\,[|R_{o\,x}|^2 T_e + T_a + 2\sqrt{|R_{o\,x}|^2 T_e T_a}\,.\,\cos\phi]\,df$$

dans laquelle :
- k est la constante de Boltzman,
- $\phi$ est le déphasage entre le bruit d'entrée et le bruit de sortie du récepteur égal à $2\pi.L_o.f/C$,
- C est la vitesse de la lumière,
- $L_o$ correspond à la longueur intrinsèque de l'amplificateur.

Ainsi, la contribution totale du bruit de corrélation s'obtient en intégrant l'équation précédente dans la bande passante de l'amplificateur et on obtient : avec

$$S_{cor} = k.[|R_{o\,x}|^2 T_e + T_a + 2\sqrt{|R_{o\,x}|^2 T_e T_a}$$

$$\frac{\sin (\alpha/2. (f_2 - f_1))}{\alpha/2. (f_2 - f_1)} .\cos(\alpha/2.(f_2 + f_1))] \, \Delta f$$

avec

$$\alpha = \frac{2\pi \, ( \, 2L \, + \, L_o)}{C}$$

$f_2$ et $f_1$ étant respectivement les fréquences de coupures haute et basse de l'amplificateur,

$\Delta f$ étant la bande passante de l'ampli, $f_2$-$f_1$,

L étant la longueur de la ligne entre l'entrée de l'amplificateur et l'antenne.

En fonction de ceci, une des caractéristiques de la présente invention réside dans le fait que l'on intercale entre l'antenne et les dits moyens de traitement des signaux, notamment son amplificateur, une ligne d'impédance donnée, fonction de l'impédance d'entrée de l'amplificateur, de longueur L très grande devant la longueur d'onde des signaux telle que le facteur de bruit de corrélation des dits moyens soit négligeable.

Dans l'équation précédente $S_{cor}$, on aura de ce fait la quantité :

$$2\sqrt{|R_{o\,x}|^2 \, T_e \, T_a} \, \frac{\sin (\alpha/2. (f_2 - f_1))}{\alpha/2. (f_2 - f_1)} .\cos(\alpha/2.(f_2 + f_1))$$

tend vers zéro lorsque $\alpha$ tend vers l'infini. Cette condition est remplie lorsque L est très grand par rapport à la longueur d'onde des signaux traités à savoir $C/f_2$-$f_1$.

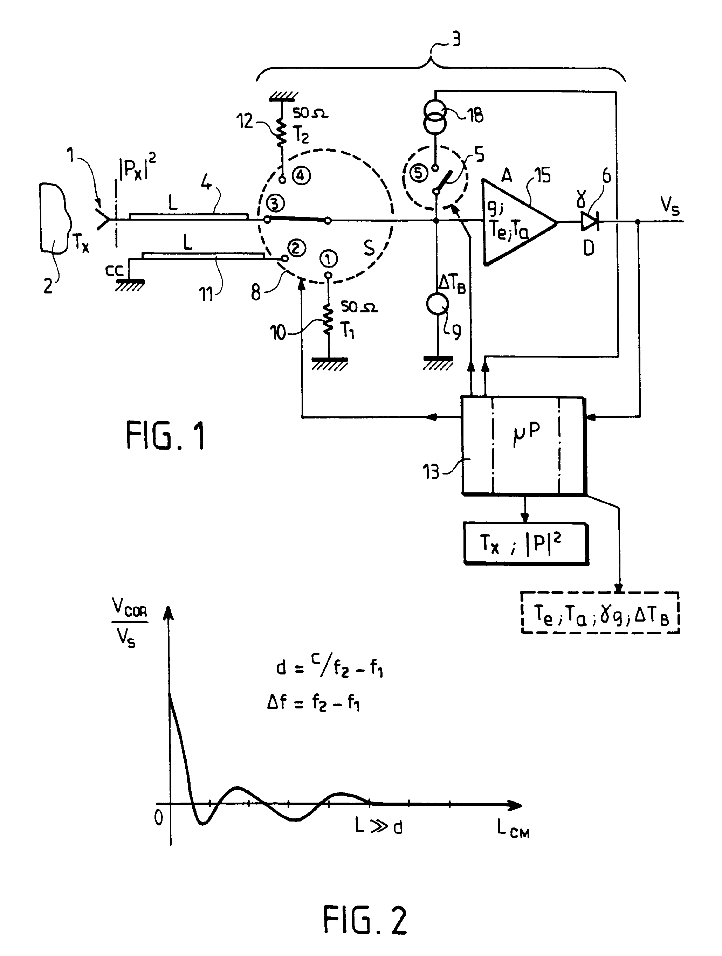

Le graphe de la figure 2 montre l'influence de la corrélation et plus précisément le rapport $V_{cor}/V_s$ en fonction de la longueur L en centimètres entre l'antenne et l'entrée de l'ampli.

On voit que le rapport tend vers zéro lorsque L est très grand devant la longueur d'onde. Par exemple, pour un ampli travaillant dans une bande passante 2 à 4 GHz, on commence à obtenir des résultats à partir d'une longueur L de l'ordre de 10 cm. Par sécurité, on utilisera une longueur de 40 cm par exemple.

Par ailleurs, l'impédance de cette ligne L doit correspondre sensiblement à l'impédance d'entrée de l'amplificateur pour éviter une désadaptation. En hyperfréquence, les amplificateurs utilisés généralement ont une impédance d'entrée de l'ordre de 50 ohms c'est pourquoi on choisira un tronçon de ligne L pour conduire l'énergie de l'antenne vers l'ampli d'impédance caractéristique Zc 50 ohms.

Cela étant, on peut alors considérer que le signal radiométrique est donné par la relation évoquée précédemment à savoir :

$$V_s = g\gamma \, [T_x \, (1 - |R_{o\,x}|^2) + T_e \, |R_{o\,x}|^2 + T_a]$$

Aussi, selon un autre mode realisation du procédé de mesure de la présente invention, on dirige les signaux reçus par l'antenne, via la dite longueur de ligne L, vers l'entrée de moyens de traitement telle que l'on recueille en sortie la dite tension $V_s$ puis on calcule périodiquement tous les paramètres en modifiant cycliquement la structure des dits moyens.

La figure 1 montre à titre d'exemple le schéma d'un dispositif de mesure de température $T_x$ d'un matériau ou d'un objet quelconque permettant la mise en oeuvre du procédé de l'invention.

On retrouve sur ce schéma une antenne de réception 1 des signaux émis par l'objet 2, dont on cherche à déterminer la température $T_x$, reliée aux moyens de traitement 3 par l'intermédiaire d'une ligne intercalaire 4 de longueur L telle que définie ci-dessus.

Plus précisément, les moyens de traitement 3 sont constitués d'un récepteur hyperfréquence 15 à amplification directe suivi d'un détecteur quadratique 6 et précédé d'un commutateur 8 multi-voies hyperfréquence.

Comme nous l'avons vu précédemment, le récepteur hyperfréquence 15 peut être constitué par un amplificateur A, de bande passante hyperfréquence, de gain g important, et de faible facteur de bruit.

Par ailleurs, étant donnée l'absence du circulateur traditionnel, on pourra réaliser cet amplificateur dans une technologie monolithique intégrée.

Pour ce qui est du détecteur quadratique 6, de gain de conversion $\gamma$, il sera avantageusement constitué par une diode de détection Schottky, facilement intégrable également.

Cela étant, selon la présente invention, pour déterminer la valeur de la température $T_x$, on va chercher à résoudre l'équation :

$$V_s = g\gamma \, [T_x \, (1 - |R_{o\,x}|^2) + T_e \, |R_{o\,x}|^2 + T_a]$$

dans laquelle les paramètres à déterminer sont $g\gamma$, $T_e$, $T_a$, $|R_{o\,x}|^2$, et $T_x$.

Nous disposons donc d'une équation à cinq inconnus, et selon le procédé de l'invention, on va donc modifier cycliquement la structure des moyens de traitement des signaux autant de fois qu'il le faut pour obtenir autant qu'équations que d'inconnus.

Cependant, pour faciliter cette résolution, selon le procédé de l'invention, on soumet en outre sélectivement et cycliquement les dits moyens de traitement à l'influence d'une source de bruit $\Delta T_B$ haute impédance (Z » Zc) afin de ne pas perturber la ligne de mesure, ce qui modifie la relation donnant la tension de sortie $V_s$ de la façon suivante :

$$V_s = g\gamma \, [T_x(1 - |R_{o\,x}|^2) + T_e|R_{o\,x}|^2 + T_a + \Delta T_B(1 + |R_{o\,x}|^2)]$$

Alors, le dispositif de la présente invention, et plus précisément les dits moyens de traitement 3 comportent, comme le montre la figure 1, en outre une source de bruit 9, apte à réinjecter du bruit complémentaire $\Delta T_B$, placée à l'entrée des dits moyens, et plus précisément à l'entrée de l'amplificateur 5.

Cette source de bruit est un élément avantageux qui permettra de faciliter la résolution du système d'équations.

A ce sujet, le dit commutateur 8 présentera avantageusement au moins quatre voies hyperfréquences, qui comme le montre la figure 1, sont assujetties à :

- une charge 10, de caractéristiques connues présentant une température $T_1$,
- une ligne de longueur L, similaire à la ligne intermédiaire 4, cette ligne étant reliée à un court-circuit,
- la dite ligne intermédiaire 4 de longueur L reliée à l'antenne 1,
- une autre charge 12 de caractéristiques connues et présentant une température $T_2$,
- la dite source de bruit $9\Delta T_B$.

Les quatre différentes voies du commutateur sont repérées sur la figure par un numéro d'ordre, respectivement 1, 2, 3, et 4, entouré; le numéro d'ordre 5 entouré correspond à une commande 5, notamment logique, mettant ou non en service la dite source $\Delta T_B$.

Par ailleurs, pour commander cycliquement le dit commutateur hyperfréquence 8 et la dite commande 5, le dispositif de la présente invention comporte une unité de calcul et de synchronisation 13, afin d'autoriser en coopération avec le dit commutateur 8 et la dite commande 5, la résolution mathématique en temps réel d'un système d'équations défini à chaque état du commutateur, en vue de déterminer au moins la température $T_x$ du corps à mesurer.

Plus précisément, selon le procédé de mesure de la présente invention, cycliquement on relie l'entrée des dits moyens de traitement, ou plus précisément l'entrée du récepteur amplificateur 15, à:

- la charge 10 de température $T_1$, en utilisant le commutateur sur la voie 1,
- la dite charge 10 de température $T_1$ et la source de bruit $9 \Delta T_B$, en utilisant le commutateur sur la voie 1 et en alimentant la dite source $\Delta T_B$ via la commande 5.
- un court-circuit via la ligne 11, en plaçant le commutateur sur la voie 2,
- l'antenne 1 via la ligne 4 L, en plaçant le commutateur sur la voie 3,
- la dite antenne 1 via la dite ligne 4 et la dite source de bruit complémentaire 9, en plaçant le commutateur sur les voies 3 et en alimentant la dite source $\Delta T_B$ via la commande 5,
- la charge 12 de température $T_2$ en plaçant le commutateur sur la voie 4.

Ainsi, à chaque cycle, on obtient le système d'équations suivant :

$$V_1 = \gamma g \, [T_1 + T_a]$$
$$V_{15} = \gamma g \, [T_1 + T_a + \Delta T_B]$$
$$V_2 = \gamma g \, [T_e + T_a]$$
$$V_3 = \gamma g \, [(1 - |R_{o\,x}|^2) T_x + |R_{o\,x}|^2 T_e + T_a]$$
$$V_{35} = \gamma g \, [(1 - |R_{o\,x}|^2)T_x + |R_{o\,x}|^2 T_e + T_a + (1 + |R_{o\,x}|^2 \Delta T_B]$$
$$V_4 = \gamma g \, [T_2 + T_a]$$

Un tel système à six équations et six inconnus peut être traité par des moyens de calcul classiques tels que l'unité de calcul 13 organisée autour d'un microprocesseur, d'une carte d'interface entrée et sortie analogique (convertisseur analogique digital/digital analogique) d'une carte entrée et sortie logique (PIA) et des moyens d'affichage.

L'unité 13 permettra donc la détermination des six paramètres et notamment l'affichage des valeurs de température $T_x$ et du coefficient de réflexion de l'antenne $|R_o|^2$. On pourra en outre si le besoin est afficher les paramètres spécifiques à l'amplig $\gamma g$, $T_e$ et $T_a$, $\Delta T_B$.

En conclusion, les différents paramètres seront obtenus par les équations suivantes:

$$g\gamma = \frac{V_1 - V_4}{T_1 - T_2}$$
$$\Delta T_B = \frac{V_{15} - V_1}{V_1 - V_4} (T_1 - T_2)$$
$$|R_{o\,x}|^2 = \frac{V_{35} - V_3}{V_{15} - V_1} - 1$$
$$T_a = \frac{T_1 V_4 - T_2 V_1}{V_1 - V_4}$$
$$T_e = \frac{V_2 (T_1 - T_2) - T_1 V_4 + T_2 V_1}{V_1 - V_4}$$
$$T_x = T_1 + \frac{(T_2 - T_2)}{(V_4 - V_1)(1 - |R_{o\,x}|^2)} [(V_3 - V_1) - |R_{o\,x}|^2 (V_2 - V_1)]$$

Cette unité de calcul et de synchronisation est gérée par un programme en boucle qui comprend :

- l'initialisation de la carte logique,
- la commande des quatre voies du commutateur hyperfréquence et l'acquisition des signaux radiométriques moyennés sur une prise de "n" échantillons, par exemple n=100,
- la commande 5 mettant en service ou non la dite source de bruit $\Delta T_B$,
- le calcul des paramètres $T_x$, $|R_{o\,x}|^2$, $T_e$, $T_a$, $\gamma g$, $\Delta T_B$,
- la moyenne des paramètres sur "n" valeurs,
- l'affichage des résultats,
- le retour à l'initialisation.

Pour ce qui est de la structure des charges 10 et 12, on utilisera avantageusement des charges dont l'impédance est adaptée à celle de l'entrée de l'amplificateur et donc dans le cas présent des charges d'impédance de 50 ohms qui seront placées chacune à une température pré-établie et connue $T_1$ et/ou $T_2$.

Pour ce qui est du commutateur hyperfréquence 8, on utilisera avantageusement un montage d'éléments MES FET à quatre voies.

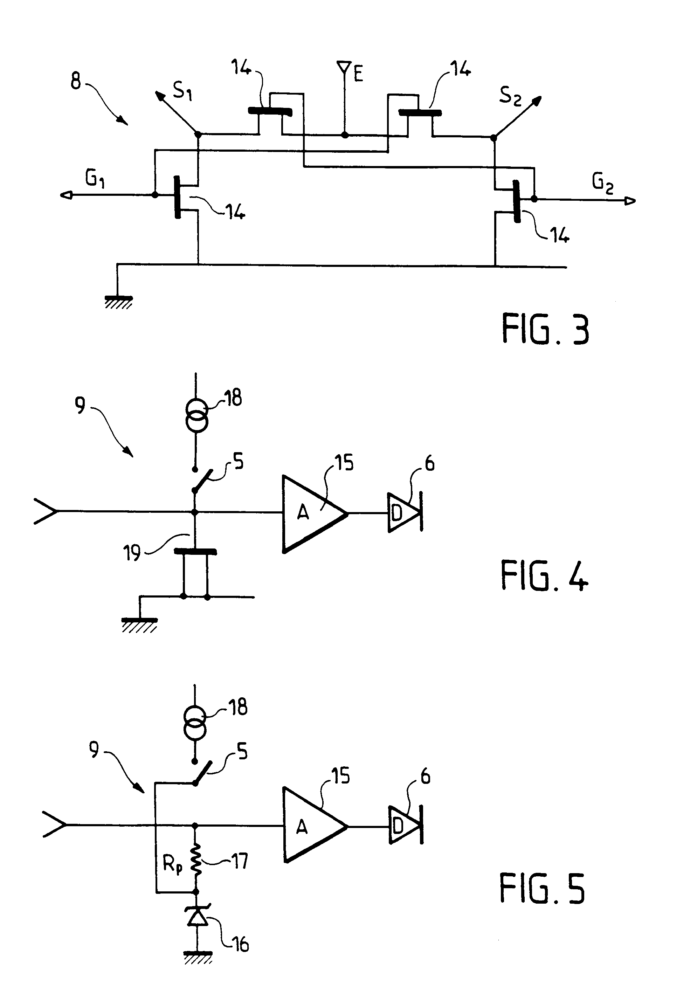

A titre d'exemple, la figure 3 montre un tel montage d'éléments MES FET pour constituer un commutateur hyperfréquence à deux voies à forte isolation.

On dispose de quatre éléments MES FET 14 disposés en séries dont les grilles sont commandées deux à deux respectivement en $G_1$ et en $G_2$ à partir de l'unité de calcul et de synchronisation 13.

Entre les points $ES_1$ et $ES_2$, on dispose alors des deux voies souhaitées E étant le point commun du commutateur.

Une telle technique est à la portée de l'homme du métier considéré et sera étendue à la réalisation d'un commutateur à quatre voies

Enfin, les figures 4 et 5 montrent deux modes de réalisation envisageables pour la source de bruit 9.

La figure 4 montre une telle source de bruit complémentaire 9 constitué par un élément 19 MES FET dont on utilise le contact Schottky polarisé en inverse jusqu'au régime d'avalanche. Le bruit d'avalanche ainsi obtenu est contrôlé par un générateur de courant 18.

En revanche, la figure 5 montre l'utilisation d'une diode 16 à avalanche placée en série avec une résistance 17 $R_P$, de valeur ohmique importante vis-à-vis de l'impédance d'entrée des dits moyens, disposées à l'entrée de ces derniers.

Ces montages sont aussi à la portée de l'homme du métier. Toutefois, l'impératif à ne pas perdre de vue consiste à réaliser une source de bruit d'impédance importante vis-à-vis de celle de l'entrée de l'amplificateur pour ne pas désadapter le circuit.

Pour ce qui est de l'antenne, on utilisera tout dispositif apte à capter le rayonnement hyperfréquence tel que cellule de mesure, applicateur, dipôle quelconque.

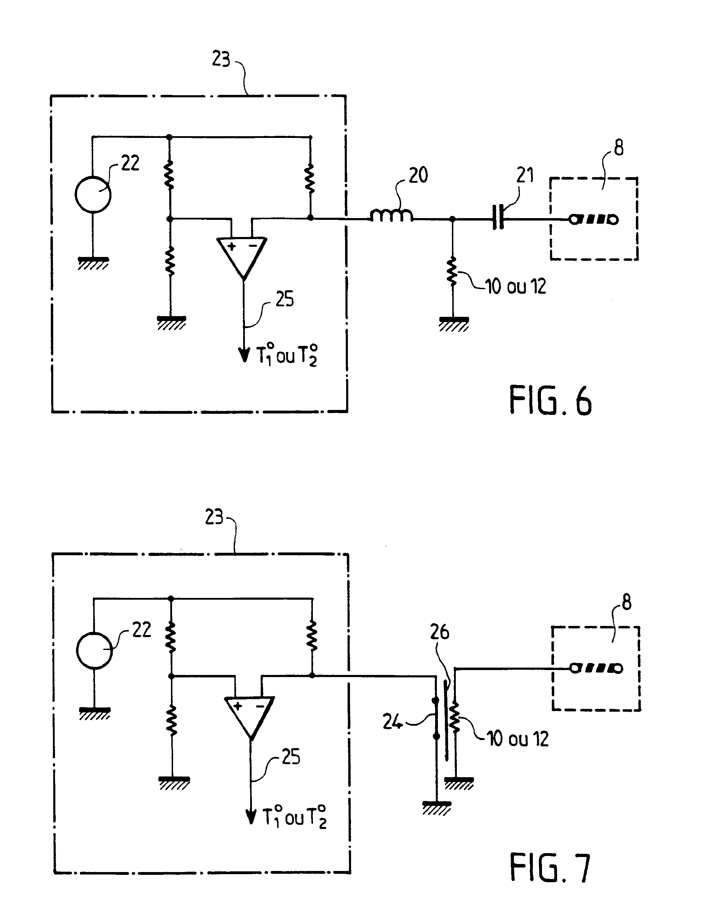

Pour déterminer les valeurs des températures $T_1$ ou $T_2$ des charges 10 ou 12, on pourra utiliser diverses méthodes telles que l'illustrent les figures 6 et 7.

Dans la figure 6, on introduit les résistances planar AsGa, constituant les charges 10, 12, de coefficient de température connu, dans un pont de wheastone 23 qui est par exemple alimenté par un générateur 22 continu ou alternatif et délivre en sortie 25 un signal proportionnel à la température $T_1$ ou $T_2$, par l'intermédiaire d'un $T_é$ de polarisation à inductance-capacité 20, 21.

Dans la figure 7, on dépose sur les résistances planar AsGa, constituant les charges 10, 12, préalablement isolées par un polymide 26, un film résistif 24 de nickelchrome (NiCr), ou de nitrure de tantal (NiTa), de coefficient de température connu. Ces résistances 24 NiCr ou NiTa sont introduites dans un pont de mesure, tel qu'un pont de wheastone 23 par exemple comme décrit précédemment.

Cela étant, le raisonnement qui vient d'être effectué part du principe que le commutateur hyperfréquence 8 est sans perte. Cependant, un tel commutateur présente inévitablement une certaine résistance caractérisée par "a" image de la transmission d'une des voies du commutateur.

Ainsi, une partie de la puissance de bruit thermique sera atténuée par le commutateur et l'on pourra considérer que le commutateur utilisé est équivalent à un atténuateur porté à une température $T_{com}$. Ainsi, la relation générale de la tension de sortie $V_s$ s'écrit :

$$V_s = g\gamma \{[1 - a (1 - |R_{o\,x}|^2) - |R_{o\,x}|^2 a^2] T_{com} +$$

$$a^2 |R_{o\,x}|^2 T_e + a(1 - |R_{o\,x}|^2) T_x + T_a +$$
$$\Delta T_B (1 + a^2 |R_{o\,x}|^2)\}$$

Il est à remarquer que $T_{com}$ peut prendre la valeur de $T_1$ pour peu que le commutateur 8 soit placé au voisinage immédiat grâce à l'intégration monolithique du dispositif.

Quant à l'autre charge 12 portée à $T_2$, elle sera isolée thermiquement du reste grâce aux puits thermiques, technique connue de l'homme du métier.

On introduit alors une nouvelle inconnue: "a", il y a donc lieu de déterminer une nouvelle équation complémentaire. Ceci est possible avec le commutateur tel que décrit précédemment et on fera par exemple l'étape suivante supplémentaire :

- commutateur placé sur la voie 2 et en alimentant la dite source $T_B$ via la ocmmande 5.

On obtiendra ainsi la relation suivante :

$$V_{25} = g\gamma [(1 - a^2)T_{com} + a^2 T_e + T_a + (1 + a^2) \Delta T_B]$$

et en faisant : $T_{com} = T_1$, la relation devient :

$$V_{25} = g\gamma [(1 - a^2)T_1 + a^2 T_e + T_a + (1 + a^2) \Delta T_B]$$

Néanmoins, un calcul identique au précédent permettra d'arriver à des relations déterminant les différentes variables si on ne néglige pas les pertes au niveau du commutateur, et si on fixe $T_{com} = T_1$ à savoir:

$$V_1 = g\gamma [(1 - a)T_1 + aT_1 + T_a]$$
$$V_{15} = g\gamma [(1 - a)T_1 + aT_1 + T_a + \Delta T_B]$$
$$V_2 = g\gamma [(1 - a^2)T_1 + a^2 T_e + T_a]$$
$$V_3 = g\gamma \{[1 - a(1 - |R_o|^2) - a^2 |R_o|^2]T_1 + a^2 |R_o|^2 T_e + (1 - |R_o|^2) a T_x + T_a\}$$
$$V_{35} = g\gamma \{[1 - a(1 - |R_o|^2) - a^2 |R_o|^2]T_1 + a^2 |R_o|^2 T_e + (1 - |R_o|^2) a T_x + T_a + \Delta T_B (1 + a^2 |R_o|^2)\}$$
$$V_4 = g\gamma [(1 - a)T_1 + aT_2 + Ta]$$

Bien sûr, il apparaît évident qu'une application particulière concerne la mesure de température en milieu industriel, ou médical, ou en domotique.

Au-delà de ce domaine d'application, il faut souligner une autre application du procédé de mesure de la présente invention pour la détermination du coefficient de réflexion hyperfréquence d'un matériau ou d'un objet quelconque.

Par ce biais, on pourra alors déterminer les propriétés diélectriques ou physiques d'un matériau par exemple à savoir taux d'humidité, structure, etc....

Naturellement, d'autres mises en oeuvre de la présente invention, à la portée de l'homme de l'art, pourraient être envisagées sans pour autant sortir du cadre de la présente invention.

## Revendications

1. Procédé de mesure de la température $T_x$ d'un matériau ou d'un objet quelconque, utilisant le rayonnement micro-onde, par lequel on capte le rayonnement micro-onde émis par l'intermédiaire d'une antenne (1), présentant un coefficient de réflexion $|R_{ox}|^2$, et on dirige les signaux reçus vers des moyens (3) de traitement des signaux, caractérisé par le fait que l'on intercale, entre l'antenne (1) et les dits moyens (3) de traitement des signaux, une ligne (4) d'impédance donnée, fonction de l'impédance d'entrée des dits moyens (3), de longueur L très grande devant la longueur d'onde des signaux traités, telle que le facteur de corrélation des dits moyens (3) soit négligeable.

2. Procédé de mesure selon la revendication 1, caractérisé par le fait que l'on dirige les signaux reçus par l'antenne (1), via la dite longueur L de ligne (4), vers l'entrée des dits moyens (3) de traitement des signaux, de gain en puissance $\gamma g$, de température de bruit d'entrée $T_e$ et de bruit de sortie $T_a$ tels que l'on recueille en sortie des dits moyens (3) de traitement des signaux une tension de sortie :

$$V_s = g\gamma [T_x(1 - |R_{ox}|^2) + T_e |R_{ox}|^2 + T_a]$$

puis on calcule périodiquement tous les paramètres en modifiant cycliquement la structure des dits moyens (3) de traitement des signaux.

3. Procédé selon la revendication 2, caractérisé par le fait que l'on soumet en outre sélectivement et cycliquement les dits moyens (3) de traitement des signaux à l'influence d'une source (9) de bruit $\Delta T_B$ haute impédance et on recueille alors en sortie des dits moyens (3) de traitement des signaux une tension correspondante à :

$$V_s = g\gamma [T_x (1 - |R_{ox}|^2) + T_e |R_{ox}|^2 + T_a + \Delta T_B(1 + |R_{ox}|^2)]$$

4. Procédé selon la revendication 3, caractérisé par le fait que cycliquement, on relie l'entrée des dits moyens (3) de traitement des signaux à :

- une charge (10) de caractéristiques connues et de température $T_1$,
- la dite charge (10) et la source (9) de bruit $\Delta T_B$,
- un court-circuit via une ligne (11) de longueur L,
- la dite antenne via la dite ligne (4) intercalaire de longueur L,
- la dite antenne (1) via la dite ligne (4) et la dite source (9) de bruit $\Delta T_B$,
- une charge de caractéristiques connues et de température $T_2$.

5. Procédé selon la revendication 4, caractérisé par le fait qu'à chaque cycle on calcule au moins la température $T_x$ en résolvant le système d'équations ainsi obtenu respectivement:

$$V_1 = \gamma g [T_1 + T_a]$$
$$V_{15} = \gamma g [T_1 + T_a + \Delta T_B]$$

$$V_2 = \gamma g [T_e + T_a]$$
$$V_3 = \gamma g [(1 - |R_{ox}|^2) T_x + |R_{ox}|^2 T_e + T_a]$$
$$V_{35} = \gamma g [(1 - |R_{ox}|^2) T_x + |R_{ox}|^2 T_e + T_a + (1 + |R_{ox}|^2 \Delta T_B)]$$
$$V_4 = \gamma g [T_2 + T_a]$$

6. Dispositif de mesure de la température $T_x$ d'un matériau ou d'un objet quelconque, utilisant le rayonnement micro-onde, autorisant la mise en oeuvre du procédé de la revendication 1, comprenant une antenne (1) de réception des signaux émis et des moyens (3) de traitement des signaux, caractérisé par le fait qu'il présente une ligne intercalaire (4) de longueur L, d'impédance donnée en fonction de l'impédance d'entrée des dits moyens (3) de traitement des signaux, placée entre l'antenne (1) et les dits moyens (3) de traitement des signaux, la dite longueur L étant très grande devant la longueur d'onde des signaux traités.

7. Dispositif selon la revendication 6, caractérisé par le fait que les dits moyens (3) de traitement des signaux sont constitués d'un récepteur hyperfréquence (15) à amplification directe, suivi d'un détecteur quadratique (6) et précédé d'un commutateur (8) multi-voies hyperfréquence.

8. Dispositif selon la revendication 6, caractérisé par le fait que les dits moyens (3) de traitement des signaux comportent en outre une source (9) de bruit apte à réinjecter du bruit complémentaire $\Delta T_B$ placée à l'entrée des dits moyens (3) de traitement des signaux.

9. Dispositif selon la revendication 8, caractérisé par le fait que le dit commutateur (8) présente quatre voies hyperfréquences assujetties à :

- une charge (10) de caractéristiques connues et de température $T_1$,
- une ligne (11) de longueur L reliée à un court-circuit,
- la dite ligne (4) intercalaire de longueur L reliée à l'antenne,
- une autre charge (12) de caractéristiques connues et de température $T_2$,
- la dite source (9) de bruit $\Delta T_B$, mise en service ou non par l'intermédiaire d'une commande 5.

10. Dispositif selon la revendication 9, caractérisé par le fait qu'il comporte une unité (13) de calcul et de synchronisation permettant d'une part cycliquement la commande du dit commutateur (8) hyperfréquence et la dite commande (5) et d'autre part la résolution mathématique en temps réel d'un système d'équations défini à chaque état du commutateur (8) en vue de déterminer au moins

la température $T_x$ du corps à mesurer.

11. Dispositif selon la revendication 7, caractérisé par le fait que le dit récepteur (15) est constitué par un amplificateur monolithique intégré, de bande passante hyperfréquence, de gain g important et de facteur de bruit faible.

12. Dispositif selon la revendication 7, caractérisé par le fait que le détecteur quadratique (6) est constitué par une diode de détecteur Schottky.

13. Dispositif selon la revendication 8, caractérisé par le fait que la source (9) de bruit complémentaire est constituée par un élément (19) MES FET, polarisé en inverse jusqu'au régime d'avalanche.

14. Dispositif selon la revendication 8, caractérisé par le fait que la source (9) de bruit complémentaire est constituée par une diode avalanche (16) placée en série avec une résistance $R_p$ (17), de valeur ohmique importante vis-à-vis de l'impédance d'entrée des dits moyens (3), disposées à l'entrée de ces derniers.

15. Dispositif selon la revendication 7, caractérisé par le fait que le dit commutateur (8) est constitué par un montage d'éléments (14) MES FET à quatre voies.

16. Dispositif selon la revendication 6, caractérisé par le fait que la ligne L est choisie avec une impédance de 50 ohms et une longueur d'au moins 10 cm pour une bande passante de fréquence de 2 à 4 GHz.

17. Dispositif selon la revendication 9, caractérisé par le fait que les dites charges (10, 12) présentent une impédance de 50 ohms et sont placées à une température prédéterminée et connue $T_1$, $T_2$.

18. Application du procédé de mesure selon l'une quelconque des revendications 1 à 5 à la détermination du coefficient de réflexion hyperfréquence $|R_{ox}|^2$ d'un matériau ou d'un objet quelconque.

**Patentansprüche**

1. Verfahren zum Messen der Temperatur $T_x$ eines Materials oder irgendwelches Gegenstands, das die Mikrowellenstrahlung verwendet, bei dem die ausgestrahlte Mikrowellenstrahlung über eine Antenne (1), die einen Reflexionsfaktor $|R_{ox}|^2$ aufweist, empfangen wird und die empfangenen Signale Signalverarbeitungsmitteln (3) zugeleitet werden, dadurch gekennzeichnet, daß zwischen der Antenne (1) und den genannten Signalverarbeitungsmitteln (3) eine Linie (4) einer gegebenen, von der Eingangsimpedanz der genannten Mittel (3) abhängigen Impedanz und einer in Betracht auf die Wellenlänge der verarbeiteten Signale derartig sehr großen Länge L eingeschaltet wird, daß der Korrelationsfaktor der genannten Mittel (3) bedeutungslos ist.

2. Meßverfahren nach Anspruch 1, dadurch gekennzeichnet, daß die von der Antenne (1) empfangenen Signale über die genannte Länge L der Linie (4) dem Eingang der genannten Signalverarbeitungsmittel (3) mit einem derartigen Leistungsverstärkungsfaktor g, einer Eingangsrauschtemperatur Te und einer Ausgangsrauschtemperatur $T_a$ zugeleitet werden, daß am Ausgang der genannten Signalverarbeitungsmittel (3) eine Spannung:
$$V_s = g\gamma [T_x(1 - |R_{ox}|^2) + T_{oe} |R_{ox}|^2 + T_a],$$
erhalten wird; anschließend werden die sämtlichen Parameter berechnet, wobei die Struktur der genannten Signalverarbeitungsmittel (3) zyklisch geändert wird.

3. Verfahren nach Anspruch 2, dadurch gekennzeichnet, daß die genannten Signalverarbeitungsmittel (3) außerdem selektiv und zyklisch dem Einfluß einer Quelle (9) eines Hochimpedanz-Rausches $\Delta T_B$ ausgesetzt werden und dann am Ausgang der genannten Signalverarbeitungsmittel (3) eine Spannung erhalten wird, die:
$$V_s = g\gamma [T_x(1 - |R_{ox}|^2) + T_e$$
$$|R_{ox}|^2 + T_a + \Delta T_B(1 + |R_{ox}|^2)],$$
entspricht.

4. Verfahren nach Anspruch 3, dadurch gekennzeichnet, daß der Eingang der genannten Signalverarbeitungsmittel (3) zyklisch mit:
   - einer Last (10) gekannter Merkmale und einer Temperatur $T_1$,
   - der gennanten Last (10) und der Quelle (9) eines Rausches $\Delta T_B$,
   - einem Kurzsckluß, über eine Linie (11) einer Länge L,
   - der genannten Antenne, über die genannte zwischengeschaltete Linie (4) einer Länge L,
   - der genannten Antenne (1), über die genannte Linie (4), und der genannten Quelle (9) eines Rausches $\Delta T_B$,
   - einer Last gekannter Merkmale und einer Temperatur T2, verbunden wird.

5. Verfahren nach Anspruch 4, dadurch gekennzeichnet, daß bei jedem Zyklus wenigstens die Temperatur Tx berechnet wird, indem das also erhaltene Äquationensystem gelöst wird, respektive:

$$V_1 = \gamma g\, [T_1 + T_a]$$
$$V_{15} = \gamma g\, [T_1 + T_a + \Delta T_B]$$
$$V_2 = \gamma g\, [T_e + T_a]$$
$$V_3 = \gamma g[(1 - |R_{o\,x}|^2)T_x + |R_{o\,x}|^2 T_e + T_a]$$
$$V_{35} = \gamma g[(1 - |R_{o\,x}|^2)T_x + |R_{o\,x}|^2 T_e + T_a + (1 + |R_{o\,x}|^2 \Delta T_B)]$$
$$V_4 = \gamma g[T_2 + T_a)$$

6. Vorrichtung zum Messen der Temperatur $T_x$ eines Materials oder irgendwelches Gegenstands, das die Mikrowellenstrahlung verwendet und die Anwendung des Verfahrens nach Anspruch 1 erlaubt, umfassende eine Antenne (1) zum Empfangen der ausgestrahlten Signale und Signalverarbeitungsmittel (3), dadurch gekennzeichnet, daß sie eine zwischen der Antenne (1) und den genannten Signalverarbeitungsmitteln (3) angebrachte, zwischengeschaltete Linie (4) einer Länge L, einer gegebenen, von der Eingangsimpedanz der genannten Signalverarbeitungsmittel (3) abhängigen Impedanz aufweist, wobei die genannte Länge L in Betracht auf die Wellenlänge der verarbeiteten Signale sehr groß ist.

7. Vorrichtung nach Anspruch 6, dadurch gekennzeichnet, daß die genannten Signalverarbeitungsmittel (3) aus einem Ultrahochfrequenz-Empfänger mit direkter Verstärkung (15) bestehen, dem ein Quadraturdetektor (6) nachgeschaltet und ein Ultrahochfrequenz-Mehrwege-Umschalter (8) vorgeschaltet ist.

8. Vorrichtung nach Anspruch 6, dadurch gekennzeichnet, daß die genannten Signalverarbeitungsmittel (3) außerdem eine am Eingang der genannten Signalverarbeitungsmittel (3) angebrachte Rauschquelle (9) umfassen, die geeignet ist, einen zusätzlichen Rausch $\Delta T_B$ zu injizieren.

9. Vorrichtung nach Anspruch 8, dadurch gekennzeichnet, daß der genannte Umschalter (8) vier Ultrahochfrequenz-Wege aufweist, die von:
   - einer Last (10) gekannter Merkmale und einer Temperatur $T_1$,
   - einer mit einem Kurzschluß verbundenen Linie (11) einer Länge L,
   - der genannten, mit der Antenne verbundenen, zwischengeschalteten Linie (4) einer Länge L,
   - einer weiteren Last (12) gekannter Merkmale und einer Temperatur $T_2$,
   - der genannten Quelle (9) eines Rausches $\Delta T_B$, ob über eine Bedienung 5 inbetriebgesetzt oder nicht,
   abhängig sind.

10. Vorrichtung nach Anspruch 9, dadurch gekennzeichnet, daß sie eine Rechen- und Synchronisierungseinheit (13) umfaßt, die es erlaubt, einerseits, den genannten Ultrahochfrequenz-Schalter (8) und die genannte Bedienung (5) zyklisch zu betätigen und, andererseits, ein in jedem Zustand des Umschalters (8) definiertes Äquationensystem mathematisch in Realzeit zu lösen, um wenigstens die Temperatur $T_x$ des zu messenden Körpers zu bestimmen.

11. Vorrichtung nach Anspruch 7, dadurch gekennzeichnet, daß der genannte Empfänger (15) aus einem integrierten monolithischen Verstärker mit Ultrahochfrequenz-Durchlaßband, einem großen Verstärkungsfaktor g und einem niedrigen Rauschfaktor besteht.

12. Vorrichtung nach Anspruch 7, dadurch gekennzeichnet, daß der Quadraturdetektor (6) aus einer Schottky-Detektordiode besteht.

13. Vorrichtung nach Anspruch 8, dadurch gekennzeichnet, daß die Quelle (9) eines zusätzlichen Rausches aus einem MESFET-Bestandteil (19) besteht, der bis zum Lawinenbetrieb sperrichtungsvorgespannt ist.

14. Vorrichtung nach Anspruch 8, dadurch gekennzeichnet, daß die Quelle (9) eines zusätzlichen Rausches aus einer mit einem Widerstand $R_P$ (17) eines bezüglich der Eingangsimpedanz der genannten Mittel (3) hochohmischen Wertes seriengeschalteten Lawinendiode besteht, die am Eingang dieser Mittel (3) angeordnet sind.

15. Vorrichtung nach Anspruch 7, dadurch gekennzeichnet, daß der genannte Umschalter (8) aus einer Montage von Vierwege-MESFET-Bestandteilen (14) besteht.

16. Vorrichtung nach Anspruch 6, dadurch gekennzeichnet, daß die Linie L mit einer Impedanz von 50 Ohm und einer Länge von wenigstens 10 cm für ein Durchlaßband einer Frequenz von 2 - 4 GHz gewählt wird.

17. Vorrichtung nach Anspruch 9, dadurch gekennzeichnet, daß die genannten Lasten (10, 12) eine Impedanz von 50 Ohm aufweisen und auf einer vorbestimmten und gekannten Temperatur $T_1$, $T_2$ eingestellt sind.

18. Anwendung des Meßverfahrens nach irgendeinem der Ansprüche 1 bis 5 für die Bestimmung des Ultrahochfrequenz-Reflexionsfaktors $|R_{ox}|^2$ eines Materials oder irgendwelches Gegenstands.

## Claims

1. Method for measuring the temperature $T_x$ of a material or any object whatsoever, making use of the microwave radiation, by which the microwave radiation emitted is detected through an aerial (1) having a reflection coefficient $|R_{o\,x}|^2$, and the signals received are directed to signal-processing means (3), characterized in that between the aerial (1) and said signal-processing means (3) is interposed a line (4) of a given impedance depending on the input impedance of said means (3) and of such a very long length L in view of the wavelength of the processed signals that the correlation factor of said means (3) is negligible.

2. Measuring method according to claim 1, characterized in that the signals received by the aerial (1) are directed via said length L of line (4) to the input of said signal-processing means (3) with a power gain g, an input noise temperature $T_e$ and an output noise temperature $T_a$ such that at the output of said signal-processing means (3) is collected an output voltage:

   $V_s = g\gamma[T_x(1 - |R_{o\,x}|^2) + T_e|R_{o\,x}|^2 + T_a]$,
   then all the parameters are periodically calculated while cyclically changing the structure of said said signal-processing means (3).

3. Method according to claim 2, characterized in that said signal-processing means (3) are, in addition, selectively and cyclically subjected to the influence of a source (9) of high impedance noise $\Delta T_B$ and at the output of said signal-processing means (3) is then collected a voltage corresponding to:

   $V_s = g\gamma [T_x(1 - |R_{o\,x}|^2) + T_e|R_{o\,x}|^2 + T_a + \Delta T_B(1 + |R_{o\,x}|^2)]$.

4. Method according to claim 3, characterized in that the input of said signal-processing means (3) is cyclically connected to:
   - a load (10) of known characteristics and temperature $T_1$,
   - said load (10) and the source (9) of noise $\Delta T_B$,
   - a short-circuit via a line (11) of a length L,
   - said aerial via said interposed line (4) of length L,
   - said aerial (1) via said line (4) and said source (9) of noise $\Delta T_B$,
   - a load of known characteristics and temperature $T_2$.

5. Method according to claim 4, characterized in that at each cycle is calculated at least the temperature $T_x$ by solving the system of equations thus obtained, respectively:

$$V_1 = \gamma g\,[T_1 + T_a]$$
$$V_{15} = \gamma g[T_1 + T_a + \Delta T_B]$$
$$V_2 = \gamma g[T_e + T_a]$$
$$V_3 = \gamma g\,[(1 - |R_{o\,x}|^2)T_x + |R_{o\,x}|^2 T_e + T_a]$$
$$V_{35} = \gamma g[(1 - |R_{o\,x}|^2)T_x + |R_{o\,x}|^2 T_e + T_a + (1 + |R_{o\,x}|^2\Delta T_B)]$$
$$V_4 = \gamma g\,[T_2 + T_a)$$

6. Device for measuring the temperature $T_x$ of a material or any object whatsoever, making use of the microwave radiation, enabling the implementation of the method according to claim 1, comprising an aerial (1) for receiving the signals emitted and signal-processing means (3), characterized in that it has an interposed line (4) of a length L, a given impedance depending on the input impedance of said signal-processing means (3) located between the aerial (1) and said signal-processing means (3), said length L being very large in view of the wavelength of the processed signals.

7. Device according to claim 6, characterized in that said signal-processing means (3) are comprised of a directly amplifying ultra-high frequency receiver (15) followed by a quadrature detector (6) and preceded by a ultra-high frequency multilane switch (8).

8. Device according to claim 6, characterized in that said signal-processing means (3) furthermore include a noise source (9), capable of re-injecting additional noise $\Delta T_B$ frequency receiver (15) followed by a quadrature detector (6).

9. Device according to claim 8, characterized in that said switch (8) has four ultra-high frequency lanes to:
   - a load (10) of known characteristics and temperature $T_1$,
   - a line (11) of a length L connected to a short-circuit,
   - said interposed line (4) of a length L connected to the aerial,
   - another load (12) of known characteristics and temperature $T_2$,
   - said source (9) of noise $\Delta T_B$, whether or not put into service through a control 5.

10. Device according to claim 9, characterized in that it includes a calculation and synchronization unit (13) allowing, on the one hand, to cyclically operate said ultra-high frequency switch (8) and said control (5) and, on the other hand, to mathematically solve in real time a system of equations defined at each state of switch (8), with a view to determine at least the temperature $T_x$ of the body to be measured.

11. Device according to claim 7, characterized in that said receiver (15) is formed by an integrated monolithic amplifier with a ultra-high-frequency passband, a large gain g and a low noise factor.

12. Device according to claim 7, characterized in that the quadrature detector (6) is formed by a Schottky detector diode.

13. Device according to claim 8, characterized in that the additional-noise source (9) is formed by a MESFET component (19) reverse biased until the avalanche operation.

14. Device according to claim 8, characterized in that the additional-noise source (9) is formed by an avalanche diode connected in series with a resistor Rp (17) of a high ohmic value with respect to the input impedance of said means (3), arranged at the input of same.

15. Device according to claim 7, characterized in that said switch (8) is formed by a mounting of four-lane MESFET components (14).

16. Device according to claim 6, characterized in that line L is chosen with an impedance of 50 ohms and a length of at least 10 cm for a 2 - 4 GHz frequency passband.

17. Device according to claim 9, characterized in that said loads (10, 12) have an impedance of 50 ohms and are set at a predetermined and known temperature $T_1$, $T_2$.

18. Implementation of the measuring method according to any of the claims 1 to 5 for determining the ultra-high-frequency reflection coefficient $|R_{o\,x}|^2$ of a material or any object whatsoever.

FIG. 1

$$d = {}^C/f_2 - f_1$$

$$\Delta f = f_2 - f_1$$

FIG. 2

13

FIG. 3

FIG. 4

FIG. 5

FIG. 6

FIG. 7